# EUROPÄISCHE PATENTANMELDUNG

(11) **EP 3 668 284 A1**
(43) Veröffentlichungstag der Anmeldung: **17.06.2020**
(21) Anmeldenummer: 19208290.7
(22) Anmeldetag: 11.11.2019
(51) Int. Cl.: H05K 3/34

(54) **VERFAHREN ZUR HERSTELLUNG EINER LEITERPLATTE UND LEITERPLATTE**

(30) Priorität: 13.12.2018 DE 102018132056
(71) Anmelder: Endress+Hauser SE+Co. KG, 79689 Maulburg (DE)
(72) Erfinder: Birgel, Dietmar, 79650 Schopfheim (DE); Burger, Paul, 79650 Schopfheim (DE)
(74) Vertreter: Andres, Angelika Maria

(57) **Zusammenfassung**

Die Erfindung betrifft ein Verfahren zur Herstellung einer Leiterplatte (1) mit zumindest einem darauf aufgelöteten Mikrolotdepot (2;2a;2b;2c,...), umfassend die Schritte:
- Aufbringen von Lotpaste (3) auf zumindest eine auf einer Oberfläche einer Leiterplatte (1) angeordnete lötfähige Kontaktfläche (4;4a;4b;4c);
- Anschließendes Aufschmelzen der Lotpaste (3), insb. ein Verlöten der Lotpaste (3) mit der lötfähigen Kontaktfläche (4;4a;4b;4c), in einem Bügel-Lötverfahren, wodurch das Mikrolotdepot (2;2a;2b;2c,...) erzeugt wird.

Ferner betrifft die Erfindung eine mit dem erfindungsgemäßen Verfahren hergestellte Leiterplatte.

## Beschreibung

Die Erfindung betrifft ein Verfahren zur Herstellung einer Leiterplatte mit zumindest einem darauf aufgelöteten Mikrolotdepot. Ferner betrifft die Erfindung eine mit dem erfindungsgemäßen Verfahren hergestellte Leiterplatte.

Insbesondere handelt es sich um eine Leiterplatte, welche für die Bestückung mit oberflächenmontierbaren Bauelemente, so genannte 'Surface Mounted Devices', kurz: SMD, vorgesehen ist. SMD-Bauelemente benötigen keine Leiterplattenlöcher zur Montage, sondern werden mit ihren Kontakten direkt an vorgesehene Anschlüsse aufgelötet. Dabei werden die SMD-Bauelemente mit Bestückungsautomaten maschinell auf mit Lotpaste versehene Kontaktflächen auf der Leiterplatte platziert und anschließend gemeinsam in einem einzigen Reflow-Prozess aufgelötet. Das Aufbringen der Lotpaste geschieht meist über ein Sieb- oder Maskendruckverfahren. Dabei wird eine das Lot und ein Flussmittel aufweisende Paste mittels eines Rakels über eine Maske verteilt. Die Maske weist genau an denjenigen Stellen Aussparungen auf, an denen die Lotpaste auf der Leiterplatte aufgebracht werden soll. Dieses Verfahren der mechanischen Verteilung setzt große Ausgangsmengen an Lotpaste voraus

Da die zunehmenede Miniaturisierung zu immer kleineren SMD-Bauelementen führt, steigen auch die Anforderungen an die Präzision bei dem Aufbringen der Lotpaste. Zudem ist es wünschenswert, die SMD-Bauelementen mit einem möglichst hohen Rasterungsgrad auf eine Leiterplatte aufzulöten. Für Mikro-SMD-Bauelemente kommt es im Zusammenhang mit maschinellen Sieb- bzw. Maskendruckverfahren aufgrund der dabei benötigten großen Ausgangsmengen an Lotpaste zu Problemen wie bspw. Lotbrücken und/oder-perlen. Um dies zu vermeiden, müssen beim Lotpastendruck Spezialschablonen und/oder sehr hochwertige Lotpasten verwendet werden, was sich als teuer und/oder aufwändig gestaltet.

Durch die "OPTIPAD" (siehe Patentschrift US 5,051,399) und die "SIPAD" (siehe bspw. Einleitung des Patents DE 693 04 911 T2) - Technik sind Verfahren bekannt geworden, durch die eine Lotdepots aufweisende Leiterplatte bereitgestellt wird. Durch die Verwendung einer Leiterplatte mit Lotdepots entfällt in der Fertigung beim Auflöten der Bauelemente der Schritt des Aufbringens der Lotpaste, so dass die vorstehend genannten Probleme reduziert bzw. vermieden werden können. Insbesondere handelt es sich um Mikrolotdepots, wobei als Mikrolotdepots im Rahmen dieser Anmeldung Lotdepots bezeichnet werden, die eine Höhe (d.h. ein Ausmaß in der zu der Ebene der Leiterplatte im Wesentlichen senkrechten Richtung) im Mikrometerbereich aufweisen d.h. eine Höhe kleiner als 100 µm (Mikrometer). Die Bauelememte werden anschließend in der Fertigung nur noch mittels eines auf die Lotdepots aufgebrachten Flussmittels auf den Mikrolotdepots befestigt und dann in einem Reflow-Verfahren verlötet. In der Patentanmeldung DE 103 49 957 A1 ist hierzu offenbart, das Flussmittel mittels eines Tintenstrahldruckkopfes auf eine Lotdepots aufweisende Leiterplatte aufzubringen.

Das OPTIPAD bzw. SIPAD Verfahren verwendet bei der Herstellung der Mikrolotdepots eine (ggf. temporäre) Lötstoppmaske bzw. Lötstoppfolie. Aus fertigungstechnischen Gründen sind diese masken- bzw. folienbasierten Verfahren zur Herstellung der Mikrolotdepots nachteilig. Dies unter anderen, das sich beim späteren Auflöten der Bauelemente das Zusammenspiel der auf die Mikrolotdepots aufzulötenden SMDs und weiterer größerer Bauelemente als ungünstig herausgestellt hat.

Der Erfindung liegt daher die Aufgabe zugrunde, eine alternative Möglichkeit zur Herstellung eines Mikrolotdepots anzugeben.

Die Erfindung wird gelöst durch Verfahren zur Herstellung einer Leiterplatte mit zumindest einem darauf aufgelöteten Mikrolotdepot und durch eine Leiterplatte mit zumindest einem darauf aufgelöteten Mikrolotdepot.

Bezüglich des Verfahrens wird die Erfindung gelöst durch ein Verfahren zur Herstellung einer Leiterplatte mit zumindest einem darauf aufgelöteten Mikrolotdepot, umfassend die Schritte:
- Aufbringen von Lotpaste auf zumindest eine auf einer Oberfläche einer Leiterplatte angeordnete lötfähige Kontaktfläche;
- Anschließendes Aufschmelzen der Lotpaste, insb. ein Verlöten der Lotpaste mit der lötfähigen Kontaktfläche, in einem Bügel-Lötverfahren, umfassend die Schritte:
   -- Pressen eines verfahrbaren Bügels auf die Lotpaste
   -- Erreichen einer vorgegebenen Löttemperatur (Lt) mittels eines den Bügel durchfließenden elektrischen Strom, wobei bei der vorgegebenen Löttemperatur die auf der Kontaktfläche aufgebrachte Lotpaste mit der lötfähigen Kontaktfläche verlötetet wird, wodurch das Mikrolotdepot erzeugt wird,
   -- Erkalten des Mikrolotdepots auf eine Temperatur unterhalb der Löttemperatur
   --Wegbewegen des Bügels von der Lotpaste.

Bei dem Aufschmelzen der Lotpaste wird vorteilhaft insbesondere die Lotpaste mit der lötfähigen Kontaktfläche verlötet. Alternativ ist es selbstverständlich auch im Rahmen der Erfindung möglich, dass die Lotpaste bereits auf der lötfähigen Kontaktfläche vor-verlötet ist (bspw. durch ein Reflow-Löten) und anschließend mittels des Bügel-Lötverfahrens das spezielle Mikrolotdepot hergestellt wird, insb. indem im Wesentlichen erst durch das Bügel-Lötverfahrens die spezielle Ausgestaltung des Mikrolotdepots, etwas dessen Höhe bestimmt wird. Daher umfasst der Begriff "Lotpaste" bei den Verfahrensschritten des Bügellötens der Erfindung auch zumindest schon (teil-)verlötete Lotpaste, d.h. eine Lotstelle.

In dem Bügel-Lötverfahren wird ein verfahrbarer Bügel eingesetzt, mit dem sich eine hohe räumliche Präzision bei der Herstellung der Mikrolotdepots erreichen lässt. Das Bügel-Selektivlötverfahren eignet sich zudem hervorragend für den Einsatz in industriellen Fertigungslinien. Weiterhin kann in vergleichsweise kurzer Lötzeit die zum Löten erforderliche Temperatur erreicht werden. Eine kürzere Lötzeit ist aufgrund der damit verbundenen beschleunigten Fertigung bei der Herstellung der Leiterplatte prinzipiell wünschenswert.

Ein großer Vorteil ist zudem, dass durch das aktive Aufpressen des Bügels mit einer Haltkraft in dem Bügel-Lötverfahren die Höhe des/der Mikrolotdepots sehr genau eingestellt werden kann. In einer vorteilhaften Weiterbildung des erfindungsgemäßen Verfahrens wird daher die Höhe des Mikrolotdepots, d.h. das Ausmaß des/der in dem Bügel-Lötverfahren erzeugten Mikrolotdepots in einer zu der Ebene der Leiterplatte im Wesentlichen senkrechten Richtung durch einen Abstand bestimmt, der in dem Bügel-Lötverfahren zwischen dem verfahrbaren Bügel und der Kontaktfläche eingestellt wird.

In einer weiteren vorteilhaften Ausgestaltung des erfindungsgemäßen Verfahrens wird die Lotpaste mittels eines kontaktlosen Dosierungsverfahrens auf die lötfähige Kontaktfläche aufgebracht. Als weiteren Begriff für das kontaktlose oder berührungslose Dosieren hat sich im Stand der Technik der Begriff "Jetten" etabliert. Beim Jetten wird eine Dosiervorrichtung, bspw. ein Dosierventil, über die Auftragsorte geführt und gibt zum geeigneten Zeitpunkt die Lotpaste ab, die dann frei fliegend aufgrund ihres Gesamtimpulses und z.B. der Schwerkraft die Kontaktfläche erreicht. Dazu werden bspw. druckbeaufschlagte Kugelsitzventile eingesetzt, deren Kugelverschluss durch pneumatische, elektromagnetische, elektropneumatische und/oder piezoelektrische Aktoren betätigt wird. Beim Jetten wird eine sehr hohe Präzision und genaue Einstellung der Dosiermenge der Lotpaste erreicht. Vorteilhaft wird in dieser Ausgestaltung also - im Gegensatz zur OPTIPAD bzw. SIDPAD Methode - kein masken- bzw. folienbasiertes mechanische Auftragsverfahren beim Aufbringen der Lotpaste verwendet, so dass die großen Ausgangsmengen an Lotpaste vermieden werden können.

In einer Ausgestaltung des erfindungsgemäßen Verfahrens wird eine ein wasserlösliches Flussmittel aufweisende Lotpaste verwendet. Dadurch ist vorteilhaft das bei dem Auflöten der Mikrolotdepots eingesetzte Flussmittel mit Wasser abwaschbar. Dadurch können nicht-verlötete Rückstände der Lotpaste von der Leiterplatte abgewaschen werden.

In einer Ausgestaltung des erfindungsgemäßen Verfahrens wird eine bleifreie Lotpaste verwendet. In einer besonders vorteilhaften Weiterbildung des erfindungsgemäßen Verfahrens wird jeweils auf mehrere Kontaktflächen Lotpaste aufgebracht und anschließend werden in einem gemeinsamen Bügel-Lötverfahren mehrere Mikrolotdepots unter Verwendung eines einzigen Bügels erzeugt, welcher Bügel in dem gemeinsamen Bügel-Lötverfahren im Wesentlichen gleichzeitig auf die auf den mehreren Kontaktflächen aufgebrachte Lotpaste gepresst wird.

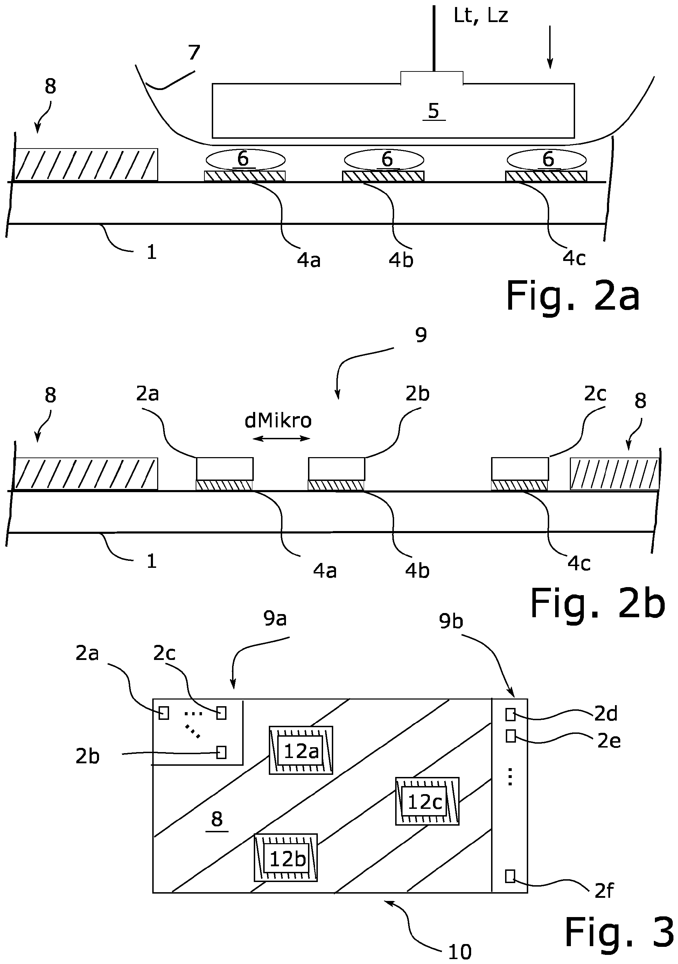

Oftmals müssen die mehreren Mikrolotdepots nur in einem begrenzten bzw. abgrenzbaren Bereich der Leiterplatte hergestellt werden. Da die Höhe der Mikrolotdepots durch den Abstand bestimmt wird, der in dem Bügel-Lötverfahren zwischen dem verfahrbaren Bügel und den mehreren Kontaktflächen eingestellt wird, weisen die gemeinsam erzeugten, mehreren Mikrolotdepots alle eine im Wesentlichen gleiche Höhe auf (gleich hohe Kontaktflächen vorausgesetzt). Selbstverständlich können auch zwei oder mehr derartige voneinander getrennte Bereiche mit mehreren Mikrolotdepots vorgesehen sein (siehe Fig. 3 der nachstehend gezeigten Ausführungsbeispiele), wobei für jeden der Bereiche ein separates Bügel-Lötverfahren durchgeführt wird. Bspw. werden mit einem ersten gemeinsamen Bügel-Lötverfahren in einem ersten Bereich mehrere Mikrolotdepots mit einer Höhe von 15 µm und mit einem zweiten gemeinsamen Bügel-Lötverfahren in einem zweiten Bereich Mikrolotdepots mit einer Höhe von 25 µm erzeugt.

In einer Ausgestaltung der Erfindung wird bei dem Bügel-Lötverfahren eine Polymid-Folie verwendet, die zwischen der auf der lötfähigen Kontaktfläche aufgebrachten Lotpaste und dem Bügel angeordnet wird. Insbesondere ist die Verwendung einer Polymid-Folie bei dem gemeinsamen Bügel-Lötverfahren vorteilhaft, wobei die Polymid-Folie zwischen der auf den mehreren lötfähigen Kontaktflächen aufgebrachten Lotpaste und dem Bügel angeordnet wird. Die Polyimid-Folie dient der elektrischen Isolation zwischen dem Bügel und der Lotpaste und eignet sich wegen der hohen Thermostabilität und ihren guten elektrischen Isoliereigenschaften. Ein bekannter Handelsname einer für die Weiterverwendung in der Elektroindustrie genutzten Polyimid-Folie ist die bspw. die Folie "Kapton" der Firma DuPont, welche eine elektrische Durchschlagfeldstärke von 303 kV/mm aufweist.
In einer weiteren Ausgestaltung des erfindungsgemäßen Verfahrens werden die mehreren Mikrolotdepots in einem Bereich der Leiterplatte erzeugt werden, welcher Bereich frei von Lötstopp ist.

Ein Lötstopp wird im Stand der Technik als Lötstopplack oder Lötstoppfolie auf die isolierenden Bereiche der Oberfläche der Leiterplatte zwischen den Kontaktflächen und Leiterbahnen aufgebracht. Der Lötstopp verhindert das Benetzen der mit ihr überzogenen isolierenden Bereiche. Dadurch wird erreicht, dass das flüssige Lot keine Brücken auf den isolierenden Bereichen ausbilden kann. Aufgrund der hohen Präzision des Bügel-Lötverfahrens und der genauen Dosierbarkeit der Lotpastenmenge wird vorteilhaft im Rahmen der Erfindung zwischen den Kontaktflächen für die Mikrolotdepots kein Lötstopp mehr benötigt. Dadurch wird der vorstehend erwähnte Nachteil von bspw. masken- bzw. folienbasierten Verfahren vermieden.

In einer weiteren Ausgestaltung des erfindungsgemäßen Verfahrens umfasst dieses den Schritt:
- Waschen der Leiterplatte mit Wasser, wobei bei dem Waschen nicht-aufgelötete Lotpaste von der Leiterplatte entfernt wird.

Bezüglich der Leiterplatte wird die Erfindung gelöst eine Leiterplatte mit zumindest einem Mikrolotdepot, die in einem Verfahren erfindungsgemäßen Verfahren hergestellt ist. Die Verwendung eines Bügel-Lötverfahrens beim Erzeugen des/der Mikrolotdepots ist deutlich erkennbar, bspw. anhand des Abdrucks des Bügels auf dem/den Mikrolotdepot/s.

In einer Ausgestaltung der erfindungsgemäßen Leiterplatte weist/weisen das/die Mikrolotdepot/s einer zu in der zu der Ebene der Leiterplatte im Wesentlichen senkrechten Richtung ein Ausmaß von höchstens 80 µm auf und insbesondere in einer zu der Ebene der Leiterplatte im Wesentlichen parallelen Richtung ein Ausmaß von höchstens 200 µm auf.

In einer Ausgestaltung der erfindungsgemäßen Leiterplatte weisen zumindest zwei benachbarte der mehreren Mikrolotdepots einen Abstand zueinander auf, der kleiner als 500 µm, insbesondere kleiner als 150 µm ist.

Wie bereits vorstehend genannt eignet sich die Erfindung insbesondere für Mikrolotdepots mit besonders kleinen Dimensionen und einem hohen Rasterungsgrad d.h. einem besonders kleinen Abstand zwischen zwei benachbarten Mikrolotdepots.

In einer Ausgestaltung der erfindungsgemäßen Leiterplatte grenzt an einen das/die Mikrolotdepot/s aufweisenden Bereich ein einen Lötstopp aufweisender weiterer Bereich an

Diese Ausgestaltung eignet sich insbesondere, wenn auf der Leiterplatte neben dem das/die Mikrolotdepot/s aufweisenden Bereich ein weiterer daran angrenzender Bereich vorgesehen ist, auf den größere Bauelemente bspw. SMD oder THT Bauelemente, aufgelötete werden sollen.

Die Leiterplatte kann dann insbesondere bei der Bestückung in der Fertigung derart weiterverarbeitet werden, dass nur auf den weiteren Bereich selektiv Lotpaste aufgebracht wird, wohingegen der/die das/die Mikrolotdepot/s aufweisende/n Bereich/e frei von Lotpaste bleibt/bleiben. Die und die Lotpaste nur in dem den Lötstopp aufweisenden weiteren Bereich aufgebracht werden muss. Die größeren Bauelemente benötigen auch entsprechend größere Lotstellen bzw. Lotpastenmengen, daher treten hier die eingangs genannten Nachteile beim mechanischen masken- bzw. folienbasierten Lotpastenauftrag nicht auf. Bei den größeren Bauelementen handelt es sich bspw. um Bauelemente mit Abmessungen von zumindest 1 mm Länge und 0,5mm Breite für ein 2-poliges Bauelement.

Vorteilhaft ist also insbesondere die Verwendung der erfindungsgemäßen Leiterplatte für eine derartige Mischbestückung d.h. mit SMD- Bauelementen aus im Wesentlichen zwei unterschiedlichen Größenordnungen, insb. nämlich dem Mikrometerbereich und dem Millimeterbereich.
Die Erfindung wird anhand der nachfolgenden, nicht maßstabsgetreuen Figuren näher erläutert, wobei gleiche Bezugszeichen gleiche Merkmale bezeichnen. Wenn es die Übersichtlichkeit erfordert oder es anderweitig sinnvoll erscheint, wird auf bereits erwähnte Bezugszeichen in nachfolgenden Figuren verzichtet. Es zeigen:
Fig. 1a bis 1c: Eine erste Ausgestaltung des erfindungsgemäßen Verfahrens;
Fig. 2a, 2b: Eine zweite Ausgestaltung des erfindungsgemäßen Verfahrens der erfindungsgemäßen Leiterplatte;
Fig. 3: Eine Ausgestaltung der erfindungsgemäßen Leiterplatte.

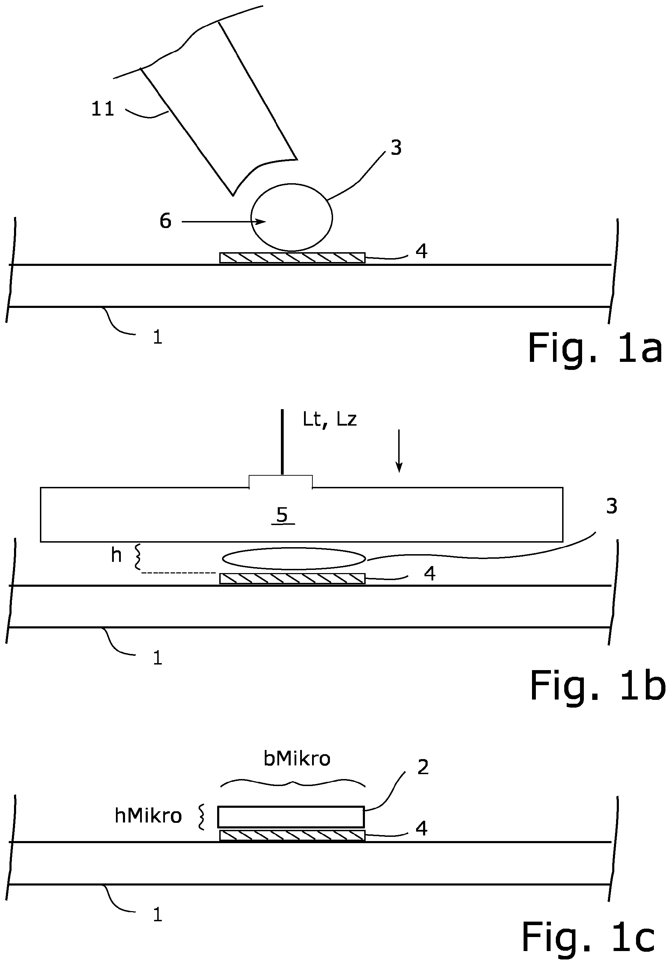

Figuren 1a bis 1c zeigen Verfahrensschritte einer Ausgestaltung des erfindungsgemäßen Verfahrens zur Herstellung einer Leiterplatte 1 mit einem Mikrolotdepot 2 in einer Schnittansicht der Leiterplatte 1. Dabei wird zunächst mittels einer Dosiervorrichtung 11 auf eine lötfähige Kontaktfläche 4 Lotpaste 6 aufgebracht, siehe Fig. 1a. Anschließend, siehe Fig. 1b, wird ein in der Ebene der Leiterplatte 1 sowie in einer dazu senkrechten Richtung (=Höhe) verfahrbarer Bügel 5 auf die Lotpaste 6 gepresst bzw. auf ein zwischen der Lotpaste 6 und dem Bügel 5 angeordnetes Polymid-Band 7 (hier nicht gezeigt ist, siehe Fig. 2a). Eine vorgegebene Löttemperatur Lt wird mittels eines den Bügel 5 durchfließenden elektrischen Stroms erreicht. Die Löttemperatur Lt, welche abhängig von Schmelztemperatur des Lots der Lotpaste 6 gewählt wird, wird dabei für eine Lötzeit Lz gehalten. Dabei wird, siehe Fig. 1c, das Mikrolotdepot 2 erzeugt, wobei vorteilhaft die Höhe hMikro des Mikrolotdepots 2 über den Abstand h zwischen Bügel 5 und Kontaktfläche 4 in der zu der Ebene der Leiterplatte 1 im Wesentlichen senkrechten Richtung bestimmt wird, bspw. indem während dem Bügellöten der Bügel 5 mit einer Haltekraft in einem Abstand h von der Kontaktfläche 4 auf die Lotpaste 6 gepresst wird. Der Abstand h bzw. entsprechend die Höhe hMikro des Mikrolotdepots liegt typischerweise im Bereich von 15 µm bis zu 50 µm. Das hier gezeigte Mikrolotdepot 2 weist bspw. eine Höhe hMikro von 20 µm und eine Breite bMikro von 100 µm.

Anschließend wird das Erkalten der Lötstelle auf eine Temperatur unterhalb der Schmelztemperatur des Lots abgewartet und schließlich der Bügel 5 von dem beim Bügellöten gebildeten Mikrolotdepot 2 wegverfahren. Zum automatisierten Bügellöten (auch: Thermodenlöten) ausgebildete Lötautomaten werden bspw. von der Firma "Eutect" hergestellt und vertrieben.

Die Lotpaste 6 enthält in einer Ausgestaltung ein wasserlösliches Flussmittel 3, siehe Fig. 1a. Dadurch werden zum einen die Benetzungseigenschaften des Lots beim Bügellöten günstig beeinflusst. Aufgrund der Wasserlöslichkeit können nach Erzeugung des Mikrolotdepots 2 etwaige Rückstände nicht-verlöteter Lotpaste 6 entfernt werden. Dadurch wird vorteilhaft eine Lot-Sattelitenbildung in einem nachfolgenden Reflow-Prozess vermieden. In diesem werden ein für das Mikrolotdepot 2 vorgesehenes Mikro-SMD-Bauelement und ggf. für weitere Kontaktflächen vorgesehene weitere Bauelemente, insb. SMD-Bauelemente aus dem Millimeterbereich, auf die Leiterplatte 1 aufgelötet.

Figuren 2a bis 2b zeigen Verfahrensschritte einer weiteren Ausgestaltung des erfindungsgemäßen Verfahrens zur Herstellung einer Leiterplatte 1 mit mehreren Mikrolotdepots 2a,2b,2c in einer Schnittansicht der Leiterplatte 1. Der Einfachheit halber ist der Verfahrensschritt des Dosierens der Lotpaste 6 nicht näher dargestellt ist, siehe hierzu vorstehend erläuterte Fig. 1a. Selbstverständlich ist das im folgenden erläuterte Ausführungsbeispiel unabhängig von der konkreten Anzahl der Mikrolotdepots. Es handelt sich um mehrere, d.h. zumindest zwei Mikrolotdepots, wobei hier und im Folgenden ein Beispiel mit drei Mikrolotdepots 2a,2b,2c gezeigt bzw. erläutert wird.

Der Bügel 5 presst nun gleichzeitig auf Lotpaste 6, welche auf mehrere Kontaktflächen 4a,4b,4c aufgebracht ist, wobei eine Polymid-Folie 7 verwendet wird, die zwischen der Lotpaste 6 und dem Bügel 5 angeordnet ist. Die Verfahrensschritte entsprechen im Wesentlichen denen schon im Zusammenhang mit Fig. 1a-c erläuterten Schritten, wobei hier vorteilhaft mit einem einzigen Bügel 5 in einem gemeinsamen Bügellöten die Mikrolotdepots 2a,2b,2c erzeugt werden. Die beiden benachbarten Mikrolotdepots 2a, 2b weisen einen maximalen Abstand dMikro der Mikrolotdepots 2a, 2b, 2c von 180 µm zueinander auf.

Der Bereich 9 mit den Mikrolotdepots 2a, 2b, 2c ist frei von Lötstopp 8. Während zwischen den Mikrolotdepots 2a,2b,2c durch den hohen Präzisionsgrad beim Dosieren der Lotpaste 6 und/oder dem Bügellöten kein Lötstopp 8 benötigt wird, weist die Leiterplatte 1 einen weiteren Bereich mit einem bspw. als Folie ausgebildeten Lötstopp 8 auf.

Dies ist in Fig. 3 näher dargestellt, in der eine Draufsicht auf eine Oberfläche einer weiteren Ausgestaltung einer mit dem erfindungsgemäßen Verfahren hergestellten Leiterplatte 1 dargestellt ist. Die Leiterplatte 1 weist einen ersten Bereich 9a mit einer Vielzahl von Mikrolotdepots 2a,2b,2c,... und einen zweiten Bereich 9b mit einer Vielzahl von Mikrolotdepots 2d,2e,2f,.... auf, die jeweils auf dazugehörigen Kontaktflächen 4a,4b,4c,...,4d,4e,4f (hier nicht gezeigt) erzeugt wurden. Die Mikrolotdepots 2a,2b,2c des ersten Bereichs 9a wurden insbesondere in einem ersten gemeinsamen Bügellöten mit dem Bügel 5 erzeugt. Anschließend wurde der Bügel 5 verfahren und die Mikrolotdepots 2d,2e2cf des zweiten Bereichs 9b wurden in einem zweiten gemeinsamen Bügellöten mit dem Bügel 5 2d,2e,2f,.... erzeugt.

Der Einfachheit halber sind die üblicherweise noch auf der Leiterplatte 1 vorhandenen Leiterbahnen hier nicht näher dargestellt. Beide der Bereiche 9a,9b sind frei von Lötstopp 8, wohingegen weist der weitere Bereich 10 einen Lötstopp 8 auf. Der Lötstopp 8 wird bei dem gemeinsamen Löten der weiteren SMD-Bauelemente auf die weiteren Kontaktflächen 12a,12b,12c benötigt. Diese weiteren Bauelemente sind wie vorstehend erwähnt typischerweise um einiges größer als die für die Mikrolotdepots 2a,2b,2c,...,2d,2e,2f vorgesehenen Bauelemente.

Die Erfindung eignet sich insbesondere für Anwendungen, in denen derartige mischbestückte Situationen auftreten. Dies ist häufig der Fall, wenn die Leiterplatte in einem Feldgerät der Automatisierungstechnik eingesetzt wird, da hier eine Vielzahl von verschiedenartigen elektronischen und/oder elektrischen Bauelementen mit spezifischen Funktionen verbaut wird, bspw. in einer Baugruppe einer Elektronikeinheit, insb. Transmittereinheit, eines derartigen Feldgeräts.

In der Fertigung einer derartigen Elektronikeinheit kann vorteilhaft eine in Fig. 3 gezeigte Leiterplatte 1 verwendet werden, für die beim Auflöten in der Fertigung Lotpaste mit dem mechanischen Masken- bzw. Siebdruck nur noch in dem weiteren Bereich 10 mit den Kontaktflächen 12a,12b,12c aufgetragen werden muss, nicht aber in dem ersten Bereich 9a und dem zweiten Bereich 9b mit den Mikrolotdepots 2a,2b,2c,...,2d,2e,2f.

Vorteilhaft werden dadurch die vorstehend erwähnten Probleme beim mechanischen Lotpastenauftrag im Sieb- oder Maskendruck im Zusammenhang mit SMD-Bauelementen aus dem Mikrometerbereich vermieden. Letztere müssen nur noch auf den Mikrolotdepots 2a,2b,2c,...,2d,2e,2f angeordnet und ggf. dort befestigt werden, bspw. indem sie mit Flussmittel aufgeklebt werden. Anschließend werden alle SMD-Bauelemente in einem gemeinsamen Reflow-Prozess mit den jeweils für sie vorgesehenen Kontaktflächen 4a,4b,4c,...,4d,4e,4f, 12a,12b, 12c verlötet.

Eine derartig hergestellte Baugruppe, für die eine Leiterplatte 1 mit zumindest einem Bereich 9a;9b mit Mikrolotdepots 2,2a,2b,2c;...2c,2d,2e,... verwendet wird, weist vorteilhaft weniger Defekte wie etwa Kurzschlüsse, Unterbrechungen und/oder Lotperlen in diesem Bereich auf, im Vergleich zu einer Baugruppe mit einer Leiterplatte aus dem Stand der Technik, bei der eine Leiterplatte ohne Lotdepots (d.h. ausschließlich mechanischer Lotpastenauftrag mit Masken- bzw. Siebdruck) verwendet wurde. Dies gilt insbesondere für den Fall das hochpolige und/oder Mikro-SMD-Bauelemente aufgelötet werden.

### Bezugszeichen und Symbole

- 1: Leiterplatte
- 2,2a,2b,2c...: Mikrolotdepot
- 3: Lotpaste
- 4, 4a,4b,4c: Kontaktflächen
- 5: Bügel
- 6: Flussmittel
- 7: Polymid-Folie
- 8: Lötstopp
- 9,9a,9b: Bereich mit Mikrolotdepots
- 10: weiterer Bereich mit Lötstopp
- 11: Dosiervorrichtung
- 12a,12b,12c: weitere Kontaktflächen

- Lt: Löttemperatur
- Lz: Lötzeit
- h: Abstand Bügel-Kontaktfläche
- hMikro: Höhe Mikrolotdepot
- bMikro: Breite/Länge Mikrolotdepot
- dMikro: Abstand benachbarter Mikrolotdepots

## Patentansprüche

1. Verfahren zur Herstellung einer Leiterplatte (1) mit zumindest einem darauf aufgelöteten Mikrolotdepot (2;2a;2b;2c,...), umfassend die Schritte:
- Aufbringen von Lotpaste (3) auf zumindest eine auf einer Oberfläche einer Leiterplatte (1) angeordnete lötfähige Kontaktfläche (4;4a;4b;4c);
- Anschließendes Aufschmelzen der Lotpaste (3), insb. ein Verlöten der Lotpaste (3) mit der lötfähigen Kontaktfläche (4;4a;4b;4c), in einem Bügel-Lötverfahren, umfassend die Schritte:
-- Pressen eines verfahrbaren Bügels (5) auf die Lotpaste (3);
-- Erreichen einer vorgegebenen Löttemperatur (Lt) mittels eines den Bügel (5) durchfließenden elektrischen Strom, wobei bei der vorgegebenen Löttemperatur die auf der Kontaktfläche (4;4a;4b;4c) aufgebrachte Lotpaste (3) mit der Kontaktfläche (4;4a;4b;4c) verlötetet wird, wodurch das Mikrolotdepot (2;2a;2b;2c,...) erzeugt wird,
-- Erkalten des Mikrolotdepots (2;2a;2b;2c,...) auf eine Temperatur unterhalb der Löttemperatur (Lt)
--Wegbewegen des Bügels (5) von der Lotpaste (3).

2. Verfahren nach Anspruch 1, wobei das Ausmaß des/der in dem Bügel-Lötverfahren erzeugten Mikrolotdepots (2;2a;2b;2c,...) in einer zu der Ebene der Leiterplatte (1) im Wesentlichen senkrechten Richtung durch einen Abstand (h) bestimmt wird, der in dem Bügel-Lötverfahren zwischen dem verfahrbaren Bügel (5) und der Kontaktfläche (4;4a;4b;4c) eingestellt wird.

3. Verfahren nach Anspruch 1 oder 2,
wobei die Lotpaste (3) mittels eines kontaktlosen Dosierungsverfahrens auf die lötfähige Kontaktfläche (4;4a;4b;4c) aufgebracht wird.

4. Verfahren nach zumindest einem der vorherigen Ansprüche,
wobei eine ein wasserlösliches Flussmittel (6) aufweisende Lotpaste (3) verwendet wird.

5. Verfahren nach zumindest einem der vorherigen Ansprüche,
wobei eine bleifreie Lotpaste (3) verwendet wird.

6. Verfahren nach zumindest einem der vorherigen Ansprüche,
wobei jeweils auf mehrere Kontaktflächen (4a;4b;4c,...) Lotpaste (3) aufgebracht wird und anschließend in einem gemeinsamen Bügel-Lötverfahren mehrere Mikrolotdepots (2a;2b;2c,...), unter Verwendung eines einzigen Bügels (5) erzeugt werden, der in dem gemeinsamen Bügel-Lötverfahren im Wesentlichen gleichzeitig auf die auf den mehreren Kontaktflächen (4a;4b;4c,...) aufgebrachte Lotpaste (3) gepresst wird.

7. Verfahren nach zumindest einem der vorherigen Ansprüche,
wobei bei dem Bügel-Lötverfahren eine Polymid-Folie (7) verwendet wird, die zwischen der auf der lötfähigen Kontaktfläche (4;4a;4b;4c) aufgebrachten Lotpaste (3) und dem Bügel (5) angeordnet wird.

8. Verfahren nach Anspruch 6 oder 7, wobei die mehreren Mikrolotdepots (2a,2b;2c,...) in einem Bereich der Leiterplatte (1) erzeugt werden, welcher Bereich frei von einem Lötstopp (8) ist.

9. Verfahren nach zumindest einem der vorherigen Ansprüche, umfassend den Schritt:
- Waschen der Leiterplatte (1) mit Wasser, wobei bei dem Waschen nicht-aufgelötete Lotpaste (3) von der Leiterplatte (1) entfernt wird.

10. Leiterplatte (1) mit zumindest einem Mikrolotdepot (2;2a;2b;2c,...), die in einem Verfahren nach zumindest einem der Ansprüche 1 bis 9 hergestellt ist.

11. Leiterplatte (1) nach Anspruch 10
wobei das/die Mikrolotdepot/s (2;2a;2b;2c,...) in einer zu in der zu der Ebene der Leiterplatte (1) im Wesentlichen senkrechten Richtung ein Ausmaß (hMikro) von höchstens 80 µm und insbesondere in einer zu der Ebene der Leiterplatte im Wesentlichen parallelen Richtung ein Ausmaß (bMikro) von höchstens 100 µm aufweist/aufweisen

12. Leiterplatte (1) nach zumindest einem der vorherigen Ansprüche 10 bis 11,
wobei zumindest zwei benachbarte der mehreren Mikrolotdepots (2a,2b;2c...) einen Abstand (dMikro) zueinander aufweisen, der kleiner als 500 µm, insbesondere kleiner als 150 µm ist.

13. Leiterplatte (1) nach zumindest einem der vorherigen Ansprüche 10 bis 12,
wobei an einen das/die Mikrolotdepot/s (2;2a;2b;2c,...) aufweisenden Bereich (9,9a,9b) ein einen Lötstopp (8) aufweisender weiterer Bereich (10) angrenzt.
